# EUROPEAN PATENT APPLICATION

(11) **EP 2 743 955 A1**
(43) Date of publication of application: **18.06.2014**
(21) Application number: 12824354.0
(22) Date of filing: 18.07.2012
(51) Int. Cl.: H01H 59/00, B81B 7/02

(54) **ELECTRONIC COMPONENT**

(30) Priority: 12.08.2011 JP 2011177341
(71) Applicant: Omron Corporation, Kyoto-shi, Kyoto 600-8530 (JP)
(72) Inventor: SANO, Akihiko, Kyoto 600-8530 (JP); FUJIWARA, Takeshi, Kyoto 600-8530 (JP); MARUYAMA, Hidenori, Kyoto 600-8530 (JP); SEKI, Tomonori, Kyoto 600-8530 (JP)
(74) Representative: Kilian Kilian & Partner
(86) International application number: PCT/JP2012/068220
(87) International publication number: WO 2013/024658

(57) **Abstract**

A first member (32) is provided with an electrostatic actuator (46), and a second member (33) is provided with a drive IC (72) for driving said electrostatic actuator (46). The first member (32) and the second member (33) are joined by join parts (35 and 36) at the outer edges thereof such that the surface on which the electrostatic actuator (46) is provided and the surface on which the drive IC (72) is provided face each other. The electrostatic actuator (46) and the drive IC (72) are hermetically sealed in a space (34) enclosed by the first member (32), the second member (33), and the join parts (35 and 36). The electrostatic (46) actuator and the drive IC (72) for driving said electrostatic actuator are thus stacked vertically, making it possible to reduce the size of the mounting footprint.

## Description

### TECHNICAL FIELD

The present invention relates to an electronic component, such as a switch, which includes an electrostatic actuator and a drive integrated circuit for driving the electrostatic actuator.

### BACKGROUND ART

For example, Fig. 1 is a MEMS switch that opens and closes a contact using an electrostatic force (Patent Document 1). The MEMS switch includes an actuator 22 and a drive IC 23. The actuator 22 includes structural members 12, 13, and 14 in which a cavity 11 is formed, and two signal contacts 15a and 15b separated from each other are provided in a surface on the structural member 12 (wiring substrate) facing the cavity 11. A movable member 16 that is not mechanically coupled to the structural members 12, 13, and 14 is accommodated in the cavity 11. In the movable member 16, a metallic layer 17 is provided on the surface opposed to the signal contacts 15a and 15b.

Drive electrodes 18a and 18b that drive the movable member 16 using an electrostatic force are provided on the upper surface of the structural member 12. Similarly, drive electrodes 19a and 19b that drive the movable member 16 using the electrostatic force are provided in the structural member 14.

The drive IC 23 inludes a switcher 20 and a drive power supply 21. The drive electrodes 18a and 19a are connected to the drive power supply 21 through the switcher 20, and the drive electrodes 18b and 19b are grounded.

In the MEMS switch, when the switcher 20 is switched to apply a voltage from the drive power supply 21 to the drive electrode 18a, the movable member 16 is attracted to the drive electrodes 18a and 18b by an electrostatic attractive force generated between the metallic layer 17 and the drive electrodes 18a and 18b, and therefore the signal contacts 15a and 15b are electrically conducted through the metallic layer 17 to turn on the switch. On the other hand, when the switcher 20 is switched to apply the voltage from the drive power supply 21 to the drive electrode 19a, the movable member 16 is attracted to the structural member 14 by the electrostatic attractive force generated between the metallic layer 17 and the drive electrodes 19a and 19b. As a result, the metallic layer 17 separates from the signal contacts 15a and 15b to turn off the switch.

However, in the MEMS switch, the drive power supply 21 and the switcher 20 (drive IC 23) are formed independently of the actuator 22 in which the structural members 12, 13, and 14 are formed into a package. Therefore, because the drive IG 23 is mounted independently of the actuator 22, a mounting footprint of the MEMS switch is enlarged and man-hour for the mounting increases. Additionally, because the actuator 22 and drive IC 23 are discretely formed, a noise is easily received on wiring between the actuator 22 and the drive IC 23, and an influence of the noise increases.

In a semiconductor device disclosed in Patent Document 2, a microelectromechanical component (MEMS tip) and an electronic component (drive IC) are mounted on an identical substrate. However, because the microelectromechanical component and the electronic component are arrayed in the identical substrate, the mounting footprint is enlarged and man-hour for the mounting increases.

### PRIOR ART DOCUMENTS

### PATENT DOCUMENTS

Patent Document 1: Japanese Unexamined Patent Publication No. 2011-70950 (Fig. 1 and Fig. 2)
Patent Document 2: Japanese Unexamined Patent Publication No. 2008-135594

### SUMMARY OF THE INVENTION

### PROBLEMS TO BE SOLVED BY THE INVENTION

The present invention has been devised to solve the technical problems described above, and an object thereof is to provide an electronic component in which the mounting footprint is reduced.

### MEANS FOR SOLVING THE PROBLEMS

In accordance with embodiments of the present invention, an electronic component includes: a first member in which an electrostatic actuator is provided; a second member in which a drive integrated circuit for driving the electrostatic actuator is provided; and join parts configured to join the first member and the second member while a surface on which the electrostatic actuator is provided in the first member and a surface on which the drive integrated circuit is provided in the second member are opposed to each other. In the electronic component, the electrostatic actuator and the drive integrated circuit are disposed in a space surrounded by the first member, the second member, and the join parts.

### EFFECT OF THE INVENTION

According to the electronic component of the present invention, the first member in which the electrostatic actuator is provided and the second member in which the drive integrated circuit is provided are joined by the join parts while opposed to each other, so that the drive integrated circuit and the electrostatic actuator can vertically be integrated. Therefore, the electronic component can be downsized to reduce the mounting footprint.

### BRIEF DESCRIPTION OF THE DRAWINGS

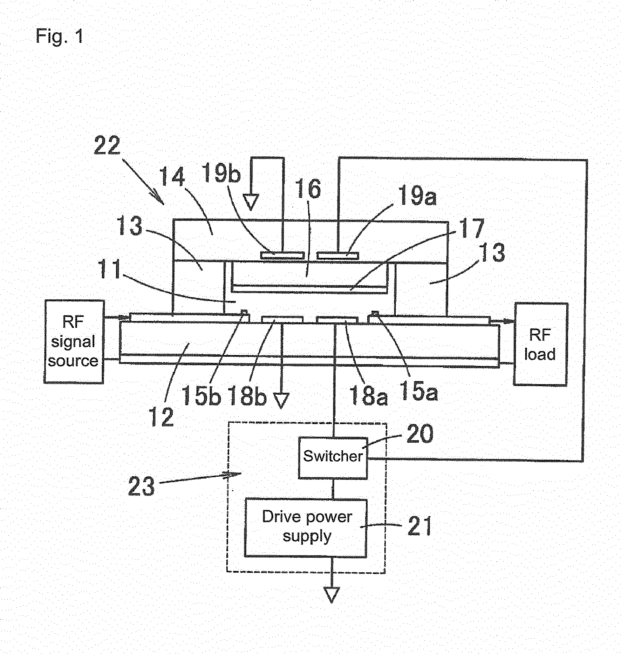

Fig. 1 is a sectional view illustrating a structure of a conventional MEMS switch.
Fig. 2 is a sectional view schematically illustrating a structure of a MEMS switch according to a first embodiment of the present invention.
Fig. 3 is a view schematically illustrating the structure of the MEMS switch according to the first embodiment of the present invention, and is a schematic sectional view in a section different from that in Fig. 2.
Fig. 4 is a plan view of a first member used in the MEMS switch according to the first embodiment of the present invention.
Fig. 5 is a bottom view of a second member used in the MEMS switch according to the first embodiment of the present invention.
Fig. 6 is a plan view illustrating one of electrostatic actuators formed in the first member of Fig. 4.
Fig. 7 is a schematic sectional view illustrating one of the electrostatic actuators formed in the first member of Fig. 4.
Fig. 8 is a circuit diagram of a charge pump used in a drive IC of the MEMS switch according to the first embodiment of the present invention.
Fig. 9 is a view illustrating a metal eutectic bonding of a join portion or a connection portion.
Fig. 10 is a sectional view schematically illustrating a modification of the MEMS switch according to the first embodiment of the present invention.
Fig. 11 is a schematic sectional view illustrating a production process of the first member constituting the MEMS switch according to the first embodiment of the present invention.
Fig. 12 is a schematic sectional view illustrating the production process of the first member constituting the MEMS switch according to the first embodiment of the present invention, and illustrates a process subsequent to (C) of Fig. 11.
Fig. 13 is a schematic sectional view illustrating the production process of the first member constituting the MEMS switch according to the first embodiment of the present invention, and illustrates a process subsequent to (C) of Fig.
Fig. 14 is a schematic sectional view illustrating a production process of the second member constituting the MEMS switch according to the first embodiment of the present invention.
Fig. 15 is a schematic sectional view illustrating a process of integrating the first member and the second member with each other to prepare the MEMS switch according to the first embodiment of the present invention.
Fig. 16 is a schematic sectional view illustrating the process of integrating the first member and the second member with each other to prepare the MEMS switch according to the first embodiment of the present invention, and illustrates a process subsequent to (B) of Fig. 15.
Fig. 17 is a schematic sectional view illustrating the process of integrating the first member and the second member with each other to prepare the MEMS switch according to the first embodiment of the present invention, and illustrates a process subsequent to (B) of Fig. 16.
Fig. 18 is a schematic sectional view illustrating the process of integrating the first member and the second member with each other to prepare the MEMS switch according to the first embodiment of the present invention, and illustrates a process subsequent to (B) of Fig. 17.
Fig. 19 is a schematic sectional view of the MEMS switch that is prepared through the process of integrating the first member and the second member with each other to prepare the MEMS switch according to the first embodiment of the present invention.
Fig. 20 is a schematic sectional view illustrating a MEMS switch according to a second embodiment of the present invention.
Fig. 21 is a schematic sectional view illustrating a MEMS switch according to a third embodiment of the present invention.
Fig. 22 is a schematic sectional view illustrating a MEMS switch according to a fourth embodiment of the present invention.

### MODES FOR CARRYING OUT THE INVENTION

Hereinafter, preferred embodiments of the present invention will be described with reference to the accompanying drawings. The present invention is not limited to the following embodiments, but various changes can be made without departing from the scope of the present invention.

### (Structure of first embodiment)

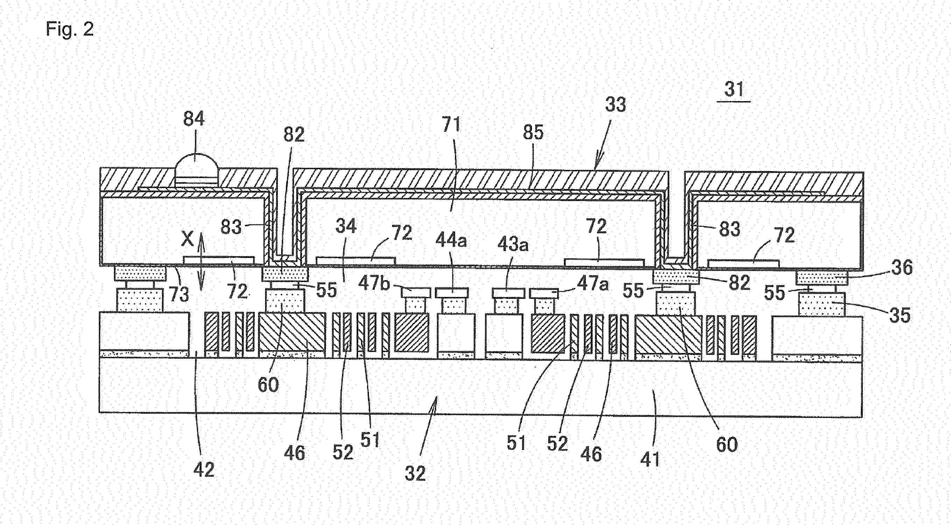

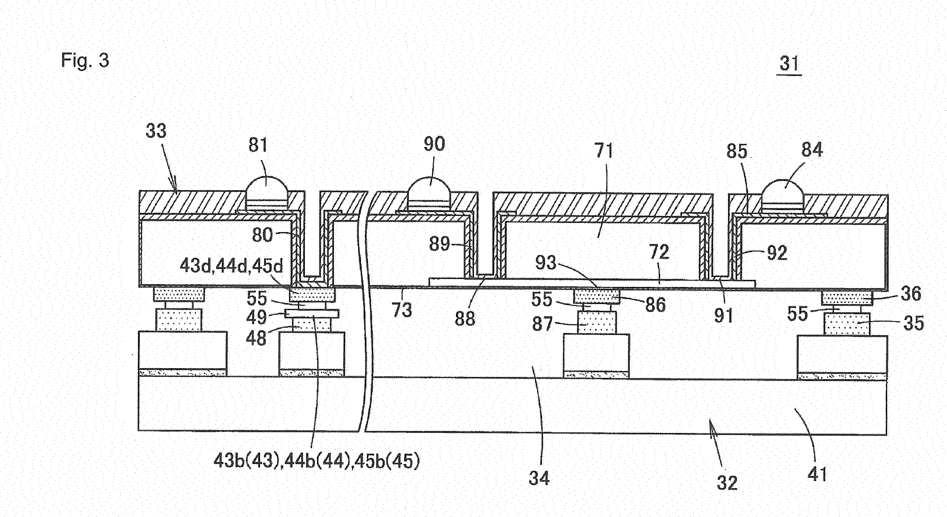

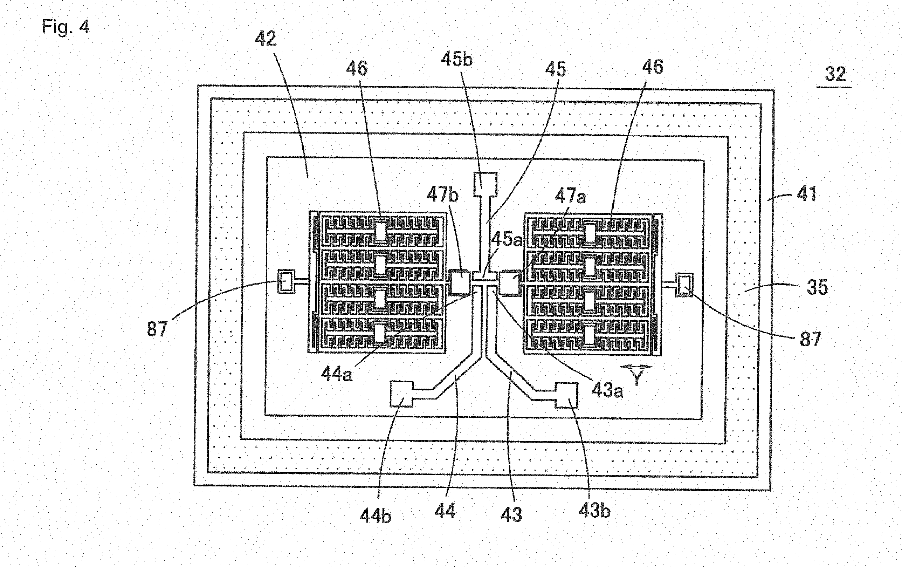

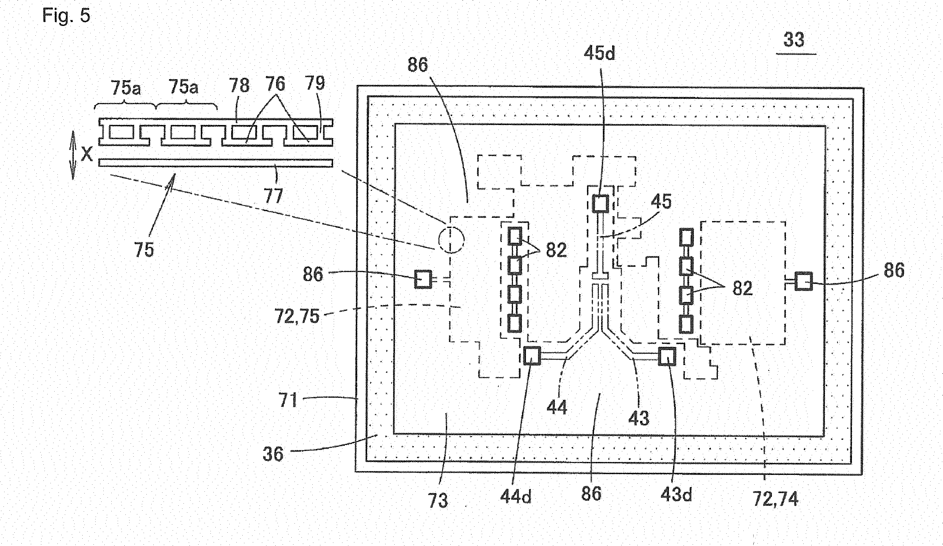

A structure of a MEMS switch (RF relay) according to a first embodiment will be described below with reference to Figs. 2 to 5. Fig. 2 is a schematic sectional view illustrating the MEMS switch according to a first embodiment of the present invention, and illustrates a section taken on a line passing through two electrostatic actuators. Fig. 3 is a schematic sectional view illustrating the MEMS switch according to the first embodiment of the present invention, and illustrates a section taken on a line passing through a drive IC (drive integrated circuit) and a pad part of a microstrip line. Fig. 4 is a plan view of a first substrate used in the MEMS switch according to the first embodiment of the present invention. Fig. 5 is a bottom view of a second member used in the MEMS switch according to the first embodiment of the present invention. Hereinafter, a direction from the first member toward the second member and a direction from the second member toward the first member perpendicularly to the first member (base substrate) or the second member (cover substrate) are considered as upward and downward, respectively.

As illustrated in Figs. 2 and 3, a first member 32 and a second member 33 are opposed to each other across a space 34, and outer peripheral portions of the first member 32 and second member 33 are joined each other by join parts, thereby forming a MEMS switch 31. That is, a cyclic join part 35 provided in an outer peripheral portion in an upper surface of the first member 32 and a cyclic join part 36 provided in an outer peripheral portion in a lower surface of the second member 33 are joined each other. The space 34 of the MEMS switch 31 is sandwiched between the second member 33 located above the space 34 and the first member 32 located below the space 34, and surrounded by the join parts 35 and 36, whereby the space 34 is hermetically sealed (encapsulated).

The first member 32 has the structure in Fig. 4. A recess 42 is formed in an upper surface of a base substrate 41, for example, a Si substrate, and three signal transmitting microstrip lines (wiring pattern part) are provided in a central portion in the recess 42. The microstrip lines include a first line 43, a second line 44, and a third line 45. The first to third lines 43 to 45 are constructed by forming a metallic wiring 49 on an insulating layer 48 (dielectric layer) such as SiN (see Fig. 3).

A leading end of the first line 43 constitutes a first contact 43a, and a pad part 43b is provided at the other end. A leading end of the second line 44 constitutes a second contact 44a, and a pad part 44b is provided at the other end. A leading end of the third line 45 constitutes a common contact 45a, and a pad part 45b is provided at the other end. The first contact 43a and the second contact 44a are disposed close to each other, and leading end portions of the first line 43 and second line 44 extend in parallel with each other. The third line 45 extends in parallel with the leading end portions of the first line 43 and second line 44, and the common contact 45a is provided so as to be opposed to the first contact 43a and the second contact 44a.

In the recess 42, electrostatic actuators 46 and 46 are provided on both sides across a region where the microstrip lines are provided. One of the electrostatic actuators 46 includes a movable contact 47a at a position opposed to the first contact 43a and the common contact 45a. The electrostatic actuator 46 translates the movable contact 47a to bring the movable contact 47a into contact simultaneously with the first contact 43a and the common contact 45a, thereby performing closing between the contacts 43a and 45a. The electrostatic actuator 46 also separates the movable contact 47a from the first contact 43a and the common contact 45a to perform opening between the contacts 43a and 45a.

Similarly, the other electrostatic actuator 46 includes a movable contact 47b at the position opposed to the second contact 44a and the common contact 45a. The electrostatic actuator 46 translates the movable contact 47b to bring the movable contact 47b into contact simultaneously with the second contact 44a and the common contact 45a, thereby performing closing between the contacts 44a and 45a. The electrostatic actuator 46 also separates the movable contact 47b from the second contact 44a and the common contact 45a to perform opening between the contacts 44a and 45a.

Accordingly, when a first main circuit (not illustrated) is connected to the pad part 43b of the first line 43 and the pad part 45b of the third line 45, one of the electrostatic actuators 46 drives the movable contact 47a, which allows the first main circuit to be opened and closed. When a second main circuit (not illustrated) is connected to the pad part 44b of the second line 44 and the pad part 45b of the third line 45, the other electrostatic actuators 46 drives the movable contact 47b, which allows the second main circuit to be opened and closed.

The cyclic join part 35 is provided in the upper surface of the base substrate 41 so as to surround the recess 42. The join part 35 is made of a metallic material.

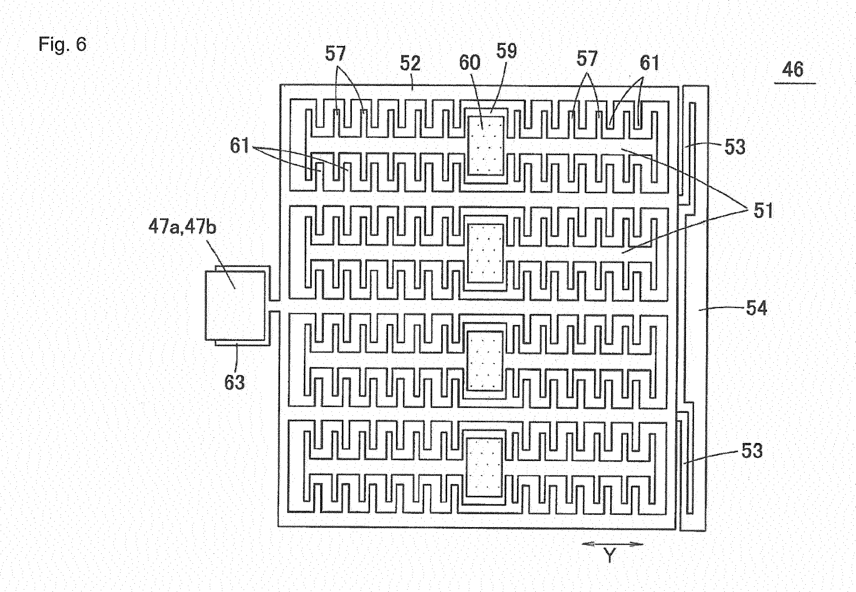

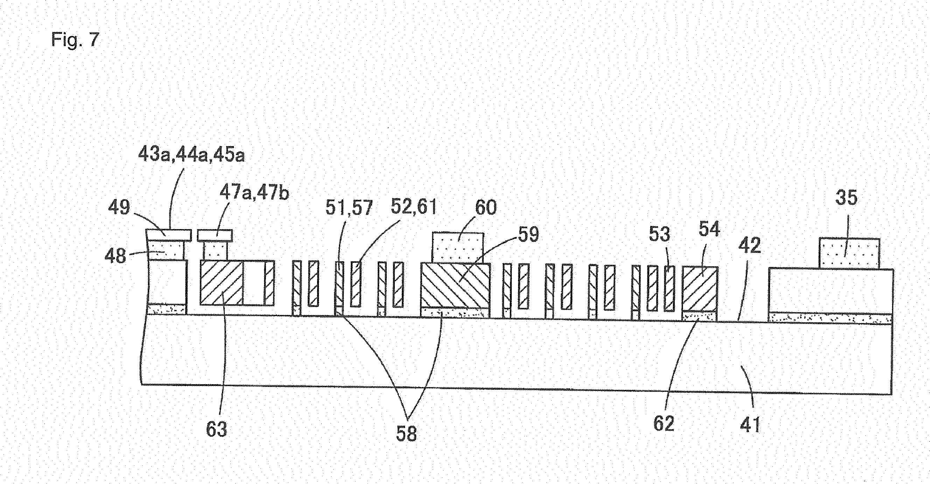

Figs. 6 and 7 illustrate a structure of the electrostatic actuator 46. Because Japanese Patent Application Nos. 2010-055556 and 2010-053056 disclose the structure of the electrostatic actuator 46, items necessary for the embodiment are described in detail while unnecessary items are neglected. The detailed structure of the electrostatic actuator 46 can be referred to in Japanese Patent Application Nos. 2010-055556 and 2010-053056.

The electrostatic actuator 46 includes a fixed electrode part 51, a movable electrode part 52, a movable spring 53, and a spring support part 54. As illustrated in Figs. 6 and 7, a plurality of fixed electrode parts 51 are disposed in parallel with each other in the upper surface of the base substrate 41. Branch electrodes 57 project symmetrically at constant intervals on both sides of the fixed electrode part 51. The lower surface of the fixed electrode part 51 is connected to the upper surface of the base substrate 41 with an insulating film 58, for example, SiO₂ interposed therebetween. A pad part 59 is provided in a substantially central portion of the fixed electrode part 51, and includes an electrode pad 60 provided on the upper surface of the pad part 59

The movable electrode part 52 is formed into a frame shape so as to surround the fixed electrode parts 51. In the movable electrode part 52, interdigital electrodes 61 are provided so as to project portions each between the branch electrodes 57 of the fixed electrode part 51. The interdigital electrodes 61 are symmetrically formed in relation to each fixed electrode part 51. In each interdigital electrode 61, a distance to the branch electrode 57 located adjacent to the interdigital electrode 61 on the side close to the movable contacts 47a and 47b is shorter than a distance to the branch electrode 57 located adjacent to the interdigital electrode 61 on the side far from the movable contacts 47a and 47b. The interdigital electrode 61 and the branch electrode 57 are configured not to come into contact with each other when the movable electrode part 52 is driven.

The movable electrode part 52 is retained by the movable spring 53 supported by the spring support part 54, and the movable electrode part 52 is horizontally retained while floating from the upper surface of the base substrate 41. The spring support part 54 is fixed to the upper surface of the base substrate 41 with an insulating film 62 interposed therebetween.

A contact support part 63 projects from a front end surface of the movable electrode part 52, and the movable contact 47a or 47b is provided on the contact support part 63.

As described later, the fixed electrode part 51 is connected to the ground through the second member 33, and an output of the drive IC is connected to the movable electrode part 52. When a DC voltage boosted by the drive IC is applied to the movable electrode part 52, the movable electrode part 52 is translated by an electrostatic force generated between the branch electrode 57 and the interdigital electrode 61, and the movable contact 47a comes into contact with the first contact 43a and the common contact 45a (or the movable contact 47b comes into contact with the second contact 44a and the common contact 45a). When the output of the drive IC is turned off, the movable electrode part 52 is retreated by an elastic returning force of the movable spring 53, and the movable contact 47a separates from the first contact 43a and the common contact 45a (or the movable contact 47b separates from the second contact 44a and the common contact 45a).

The second member 33 has a lower-surface structure in Fig. 5. The second member 33 includes a cover substrate 71 (for example, Si substrate) and a drive integrated circuit (that is, drive IC 72) prepared on the lower surface of the cover substrate 71. The surface of the drive integrated circuit is covered with a protection film 73. The cyclic join part 36 made of a metallic material is provided in the outer peripheral portion in the lower surface of the second member 33. The second member 33 and the first member 32 overlap each other such that the surface of the second member 33 on which the drive IC 72 is formed and the surface of the first member 32 on which the electrostatic actuator 46 is formed are opposed to each other with the space 34 interposed therebetween. The join part 36 of the second member 33 and the join part 35 of the first member 32 are joined each other so as to seal the space 34. As a result, the electrostatic actuator 46 and the drive IC 72 are hermetically sealed (encapsulated) in the space 34 to improve durability, corrosion resistance, and reliability of the MEMS switch 31 (that is, electrostatic actuator 46 and drive IC 72).

In consideration of a characteristic in a high-frequency band, desirably the cover substrate 71 is made of an insulator (glass) or Si having low resistivity (for example, resistivity of 500 Ω·cm or more). The space 34 may be maintained in a vacuum state, the space 34 may be filled with an inert gas such as N₂, Ar, and SF₆ by replacing air in the space 34 with the inert gas, or the space 34 may be filled with a reducing gas such asH₂.

The drive IC 72 is a boost DC-DC converter that boosts the voltage at a battery to apply the boosted voltage to the electrostatic actuator 46. Generally a mobile device has a battery voltage of 1 to 3 volts. Because the higher voltage (tens volts to a hundred volts) is desirable to drive the electrostatic actuator, the battery voltage is boosted by the drive IC 72, and applied to the electrostatic actuator 46. A charge pump is used as the drive IC 72.

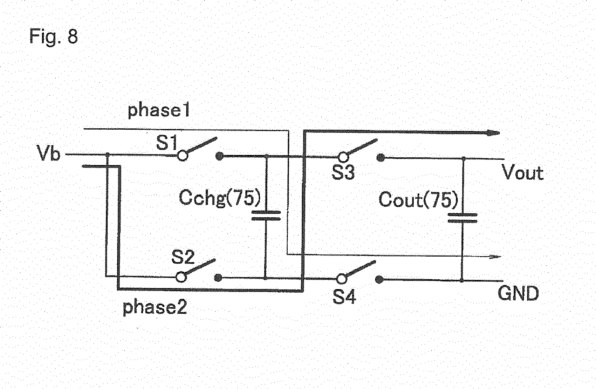

Fig. 8 illustrates a basic circuit (principle) of the charge pump. When a battery voltage Vb is input, a voltage Vout boosted by the following principle is output to the electrostatic actuator 46. In a phase 1 in which switches S2 and S3 are turned off while switches S1 and S4 are turned on, a current is passed as indicated by a thin-line arrow in Fig. 8. The current charges a capacitor Cchg until the voltage at the capacitor Cchg is equal to the battery voltage Vb. In a phase 2 in which the switches S2 and S3 are turned on while the switches S1 and S4 are turned off, the current is passed as indicated by a thick-line arrow in Fig. 8. As a result, a capacitor Cout is charged by a voltage in which the input battery voltage and the voltage at the capacitor Cchg are added to each other, and the voltage at the capacitor Cout becomes twice the battery voltage Vb. To return to the phase1, the capacitor Cout discharges to an output Vout while the capacitor Cchg is charged. The voltage is output twice the battery voltage Vb from the output Vout by alternately switching the switches S1 to S4 between the phase 1 and the phase 2. The output voltage having a further large multiplying factor can be obtained by connecting the charge pumps in Fig. 8 in series at a plurality of stages. Actually, in the charge pump, the above operation is performed using not the mechanical switches S1 to S4 in Fig. 8, but an operational amplifier or a diode.

The drive IC 72 includes a charge pump circuit 74 in which the charge pumps are connected in series at the plurality of stages and a capacitor 75 in which charges boosted by the charge pump circuit 74 are accumulated. The capacitor 75 is made of a metallic material or a conductive material, and has a section illustrated in an enlarged view in Fig. 5. That is, the capacitor 75 includes many unit capacitors 75a. When viewed from above, the one unit capacitor 75a has a size of about 20 to about 30 µm on a side.

In the cover substrate 71, a first conductive layer 78 and a second conductive layer 77 are formed in parallel so as to be opposed to each other. The first conductive layer 78 is located above the second conductive layer 77, and the second conductive layer 77 is located below the first conductive layer 78. Rectangular electrode pads 76 having a size of 20 to 30 µm on a side are regularly arrayed in at a midpoint between the first conductive layer 78 and the second conductive layer 77, and each electrode pad 76 and the first conductive layer 78 are electrically connected to each other by a via hole 79. Each unit capacitor 75a includes the electrode pad 76 and part of the second conductive layer 77 opposed to the electrode pad 76, and the unit capacitors 75a are connected in parallel with each other by the via hole 79 and the first conductive layer 78.

When the capacitor 75 is constructed by many unit capacitors 75a, no trouble is generated in the operation of the drive IC 42 even if some unit capacitors 75a have defects. The unit capacitor 75a has a size of about 20 to about 30 µm on a side, whereby a scale difference from other processes can be reduced to increase stability of the process.

In order to repeatedly operate the electrostatic actuator at high speed, it is necessary to sufficiently charge the capacitor 75. Therefore, desirably the capacitor 75 has an electrostatic capacity larger than that (an electrostatic capacity between the branch electrode 57 and the interdigital electrode 61) of the electrostatic actuator 46. Unless the high-speed operation is required, the capacitor 75 for temporal storage is not necessarily required. When the capacitor 75 has the configuration in Fig. 5, a gap between the electrode pad 76 and the second conductive layer 77 can be narrowed to increase the electrostatic capacity of the capacitor 75. The many electrode pads 76 having a size of 20 to 30 µm are regularly formed, so that a process of producing the capacitor 75 can be stabilized to improve a production yield.

As illustrated in Fig. 5, the charge pump circuit 74 and the capacitor 75 are disposed in the lower surface of the second member 33 while separating from each other, and the charge pump circuit 74 and the capacitor 75 are electrically connected to each other. When viewed from a direction perpendicular to the second member 33, the drive IC 72 (charge pump circuit 74 and capacitor 75) is disposed so as not to overlap the microstrip lines (first to third lines 43 to 45) of the first member 32 (that is, the drive IC 72 is provided in a region distant from a region opposed to the first to third lines 43 to 45). Accordingly, the microstrip line through which a high-frequency signal is transmitted is hardly influenced by the drive IC, and a noise caused by the drive IC 72 is hardly generated in the signal transmitted through the microstrip line.

All the unit capacitors 75a are oriented toward the identical direction. The unit capacitors 75a are disposed such that the direction (an X-direction in Fig. 5) of an electric field generated between the electrodes of the capacitor 75 (unit capacitor 75a) is orthogonal to the direction (the direction connecting the branch electrode 57 and the interdigital electrode 61 that is a Y-direction in Figs. 4 and 6) of the electric field generated in the electrostatic actuator 46 when viewed from the direction perpendicular to the second member 33. Therefore, advantageously the direction of the electric field generated outside the capacitor 75 by the capacitor 75 is orthogonal to the direction of the electric field driving the electrostatic actuator 46, and the electrostatic actuator 46 is hardly influenced by the electric field of the capacitor 75 (a risk of moving the movable electrode part 52 is decreased). The advantage is obtained even if the direction of the electric field generated between the electrodes of the capacitor 75 is not orthogonal to but intersects the direction of the electric field generated in the electrostatic actuator 46.

As illustrated in Fig. 3, three connection electrodes 43d, 44d, and 45d provided in the lower surface of the second member 33 are connected to the pad part 43b of the first line 43, the pad part 44b of the second line 44, and the pad part 45b of the third line 45, respectively, the pad parts provided in the first member 32. The connection electrodes 43d, 44d, and 45d are connected to a signal input/output bump 81 provided in the upper surface of the second member 33 by a through-hole 80 piercing the second member 33.

As illustrated in Fig. 2, eight connection electrodes 82 provided in the lower surface of the second member 33 are connected to the electrode pads 60 of the fixed electrode parts 51 in each of the electrostatic actuators 46 and 46 provided in the first member 32. On the other hand, each connection electrode 82 is connected to a ground wiring 85 provided in the upper surface of the cover substrate 71 by a through-hole 83 piercing the second member 33, and a ground bump 84 is provided in the ground wiring 85.

Two output electrodes 86 provided in the lower surface of the second member 33 are electrodes provided at an output terminal 93 of the drive IC 72. That is, the voltage (the voltage for driving the electrostatic actuator) boosted by the drive IC 72 can be output from the output electrode 86. As illustrated in Fig. 3, the output electrodes 86 are connected to corresponding connection electrodes 87 electrically conducted to the movable electrode parts 52 of the electrostatic actuators 46 and 46. For example, the connection electrode 87 may be provided in the spring support part 54, and electrically be connected to the spring support part 54.

As illustrated in Fig. 3, an input terminal 88 that inputs the battery voltage and a ground terminal 91 that is connected to the ground are provided in the drive IC 72. The input terminal 88 is connected to a battery voltage input bump 90 by a through-hole 89 piercing the second member 33. The ground terminal 91 is connected to the ground wiring 85 by a through-hole 92 piercing the second member 33.

in the MEMS switch 31 according to the first embodiment of the present invention, as described above, the first member 32 and the second member 33 are stacked, the electrostatic actuator 46 is provided in the first member 32, and

the drive IC 72 is provided in the second member 33, whereby the drive IC 72 and the electrostatic actuator 46 are vertically integrated.

Specifically, as illustrated in Fig. 2, the MEMS switch 31 includes the first member 32 in which the electrostatic actuator 46 is provided, the second member 33 in which the drive IC 72 is provided, and the join parts 35 and 36 that joins the first member 32 and the second member 33 while the surface on which the electrostatic actuator 46 is provided in the first member 32 and the surface on which the drive IC 72 is provided in the second member 33 are opposed to each other. The electrostatic actuator 46 and the drive IC 72 are accommodated in the space 34 surrounded by the first member 32, the second member 33, and the join parts 35 and 35.

As a result, the drive IC 72 and the electrostatic actuator 46 can be integrated with each other, and the low-voltage driving MEMS switch 31 can be downsized to reduce a mounting footprint. The drive IC 72 and the electrostatic actuator 46 are integrated with each other, which allows a wiring length between the drive IC 72 and the electrostatic actuator 46 to be shortened to reduce the influence of the external noise. The electrostatic actuator 46 and the drive IC 72 are separately provided on different substrates (first member 32 and second member 33), and the electrostatic actuator 46 and the drive IC 72 are integrated with each other by stacking the substrates, so that the MEMS switch 31 can easily be produced.

Examples of a method for joining the first member 32 and the second member 33 include fusion bonding, Si direct bonding, glass frit bonding, anodic bonding, metal diffusion bonding, metal eutectic bonding, polymer adhesive bonding, and surface-activated room-temperature bonding. The fusion bonding is a joining method in which two wafers are brought into contact with each other to generate spontaneous joining. The Si direct bonding is a method for joining a wafer including a dielectric layer subjected to a wet chemical or plasma activation treatment and a wafer not including the dielectric layer at room temperature. The glass frit bonding is a joining method in which glass frit (powder glass) is sandwiched between joining surfaces and burned in a furnace to perform vitrification. The glass frit bonding is a conventional production technology that is used worldwide to produce the MEMS device. The anodic bonding is a method in which the glass and a polished surface of the Si substrate are heated while brought into contact with each other and the voltage is applied to achieve strong joining by covalent bonding. The metal diffusion bonding is a technology for joining identical type or different types of metals at an atomic level using diffusion, and the metal diffusion bonding can implement the higher hermetic property compared with the conventional glass frit bonding or anodic bonding. The metal eutectic bonding is a method for performing the joining by an eutectic reaction between the metals, and the metal eutectic bonding for the wafer is used in an advanced MEMS package or a three-dimensional stacking technology field. One of the features of the metal eutectic bonding is that, because an alloy is melted like solder, surface flatness is improved to increase tolerance for topography or particles of a joining surface. The polymer adhesive bonding is a joining method in which joining agents such as an epoxy resin, a dry film, BCB, polyimide, and a UV setting resin are used. The surface activation normal temperature bonding is a method in which the joining is performed after the joining surface is subjected to a surface treatment in vacuum to put surface atoms into activated state in which a chemical bonding is easily formed. In the surface-activated room-temperature bonding, the joining can be performed at room temperature, or a heat treatment temperature can significantly be lowered.

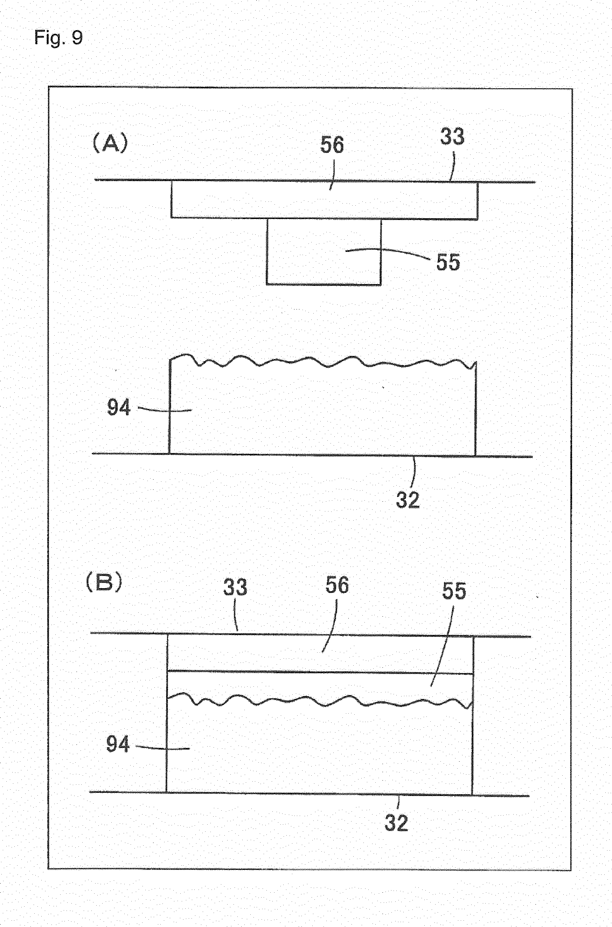

The metal eutectic bonding is used in the MEMS switch 31 of the first embodiment. For example, as illustrated in (A) of Fig. 9, the join portions or connection portions such as the join part 36 of the second member 33, the output electrode 86, and the connection electrode 82 of the second member 33are formed by a Ti material layer 56, and a join material 55 made of AuSn is provided on the lower surface of the join portions or connection portions. For example, the join portions or connection portions such as the join part 35, the connection electrode 87, and the electrode pad 60 of the first member 32 are formed by a Au layer 94. As illustrated in (B) of Fig. 9, the metal eutectic bonding is performed between join portions or connection portions of the first member 32 and second member 33 by joining the join material 55 made of AuSn to the Au layer 94 having large surface morphology, whereby the first member 32 and the second member 33 are joined each other.

Desirably the plurality of connection electrodes 87 (or electrode pads 60) for the operating voltage application or the plurality of electrode pads 60 (or connection electrodes 87) for the ground connection are provided in the electrostatic actuator 46 in order to more stabilize the characteristic of the MEMS switch 31. When it is necessary to input a control signal or switching signal to the drive IC 72, a port of the drive IC 72 and the bump in the upper surface of the second member 33 may properly be connected to each other using a through-hole.

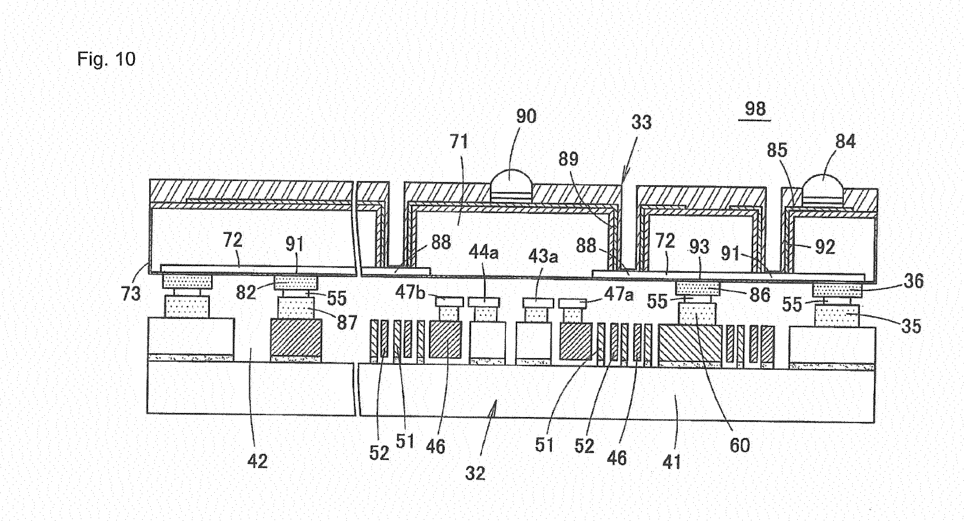

In the electrostatic actuator 46 of the first embodiment, the side of the fixed electrode part 51 is set to the ground potential, and the output voltage of the drive IC 72 is applied to the movable electrode part 52. Alternatively, as illustrated in the schematic sectional view of Fig. 10, the side of the movable electrode part 52 may be set to the ground potential while the output voltage of the drive IC 72 may be applied to the fixed electrode part 51.

In a modification in Fig. 10 of the first embodiment, the output electrode 86 provided at the output terminal 93 of the drive IC 72 is connected to the electrode pad 60 of the electrostatic actuator 46, and the output voltage of the drive IC 72 is applied to the fixed electrode part 51. The connection electrode 82 provided at the ground terminal 91 of the drive IC 72 is connected to the connection electrode 87, and the movable electrode part 52 of the electrostatic actuator 46 is connected to the ground.

The ground terminal 91 of the drive IC 72 extends to the join part 36, and the join parts 36 and 35 are also connected to the ground. In this case, the connection electrode 87 electrically conducted to the movable electrode part 52 may be connected to not the ground terminal 91 of the drive IC 72, but the join part 35 through the wiring of the base substrate 41.

### (First member production process)

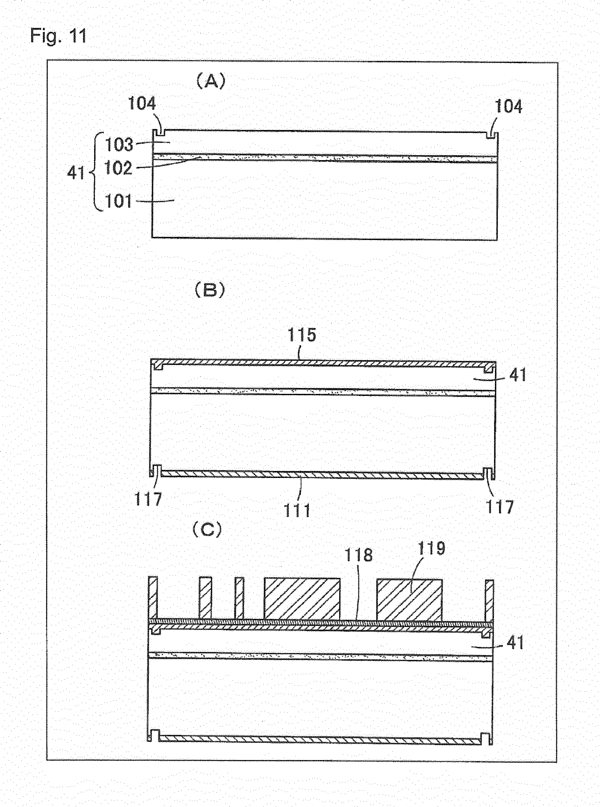

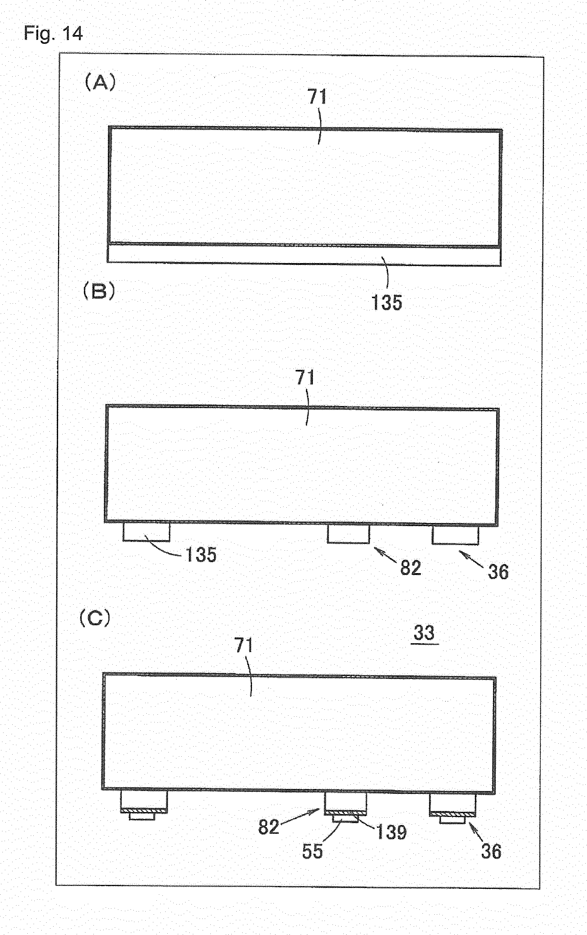

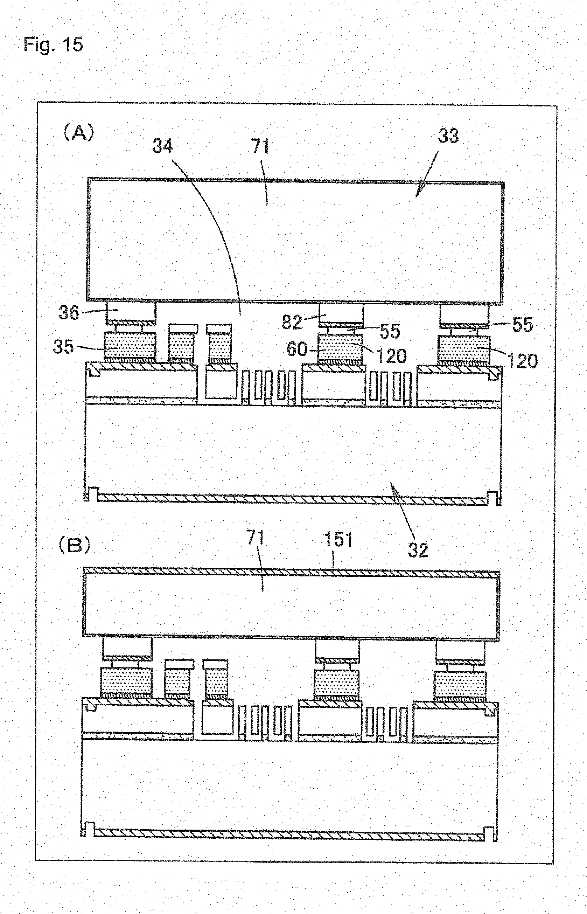

The process of producing the MEMS switch 31 according to the first embodiment of the present invention will be described below with reference to Figs. 11 to 19. Figs. 11 to 13 illustrate the process of producing the first member 32. Fig. 14 illustrates the process of producing the second member 33. Figs. 15 to 19 illustrate the process of producing the MEMS switch 31 by joining the first member 32 and the second member 33.

First the process of producing the first member 32 will be described with reference to Figs. 11 to 13. An SOI substrate in which Si substrates 101 and 103 are bonded with an oxide film 102 (SiO₂) interposed therebetween is prepared as the base substrate 41. An alignment mark 104 as a positioning reference is provided in the upper surface of the base substrate 41 ((A) of Fig. 11).

An oxide film 115 is provided on the upper surface of the base substrate 41. A positioning alignment mark 117 is provided in the lower surface of the base substrate 41 by etching ((B) of Fig. 11).

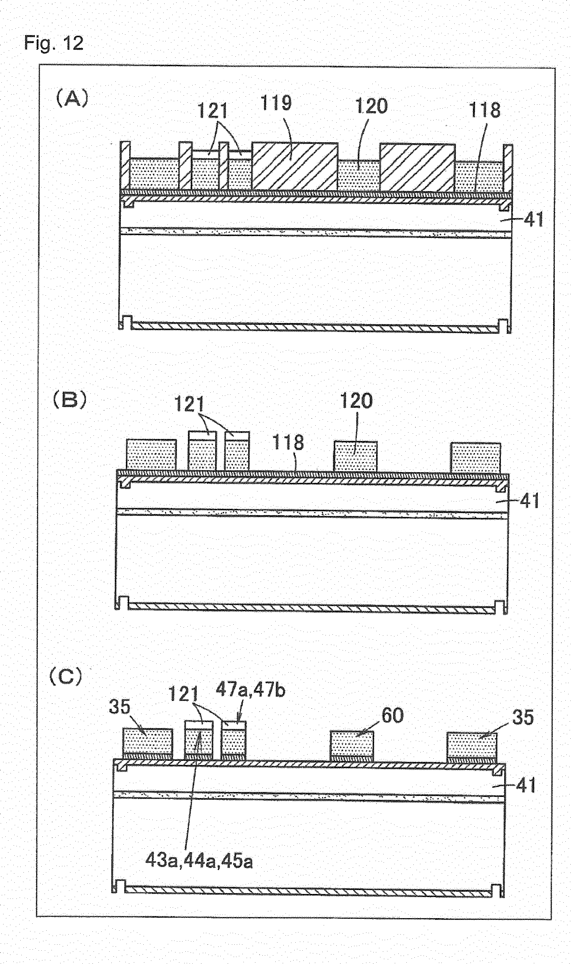

A plating underlayer 118 is formed on the surface of the base substrate 41 by sputtering. A resist film 119 is formed on the plating underlayer 118; and an opening is provided in the resist film 119 in the region where the join portion and connection portion of the first member 32 and the microstrip line are formed ((C) of Fig. 11). Then electrolytic plating is performed with the plating underlayer 118 as an electrode, and a conductive contact material is deposited in the opening of the resist film 119 to form a join/connection layer 120 ((A) of Fig. 12). Desirably noble metal is used as the contact material from the viewpoint of contact reliability. At this point, a metallic layer 121 is provided on the join/connection layer 120 in the portions constituting the microstrip line and the movable contacts 47a and 47b.

After the resist film 119 is peeled off ((B) of Fig. 12), the unnecessary plating underlayer 118 is removed with the join/connection layer 120 as a mask. As a result, the join portion and connection portion such as the join part 35 and the electrode pad 60 are formed in the upper surface of the base substrate 41 by the join/connection layer 120. The first contact 43a, the second contact 44a, and the common contact 45a are formed by the metallic layer 121 ((C) of Fig. 12).

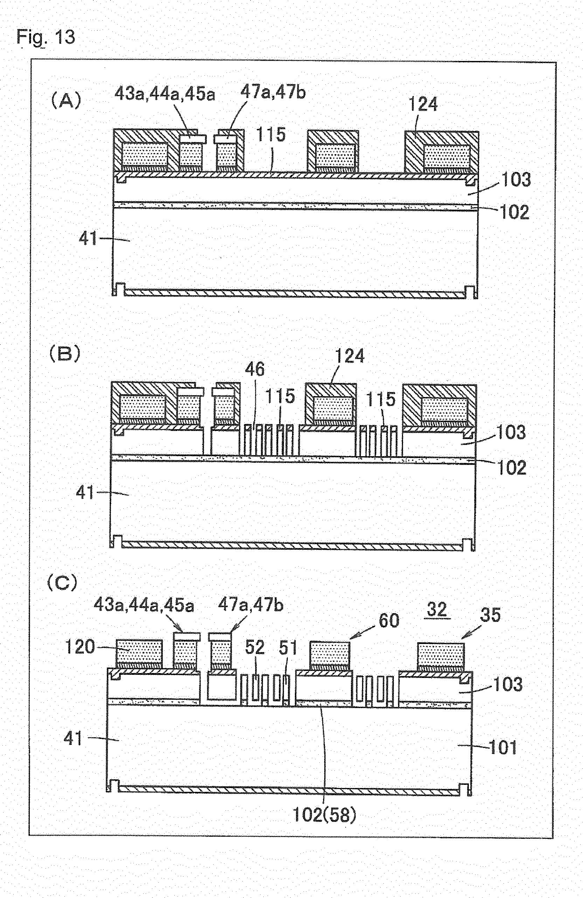

Then the upper surface of the base substrate 41 is covered with an etching mask 124 ((A) of Fig. 13). Referring to (A) of Fig. 13, in the etching mask 124, the openings are provided in the regions corresponding to the movable contacts 47a and 47b, the first contact 43a, the second contact 44a, and the common contact 45a, and the opening is also provided in the region (see (B) of Fig. 13) above the place where the electrostatic actuator 46 is disposed. In the openings of the etching mask 124, the oxide film 115 and the Si substrate 103 are etched downward ((B) of Fig. 13). In the places subjected to the etching, the oxide film 115 and the Si substrate 103 are etched into the interdigital shape in the place where the electrostatic actuator 46 is disposed.

The etching mask 124 is peeled off when the etching is performed to the lower surface of the Si substrate 103. Then the oxide film 102 on the lower surface of the movable electrode part 52 is removed by etching, and the movable electrode part 52 is movably floated from the base substrate 41 (Si substrate 101). This can be performed by forming a difficult-to-etch portion such that, for example, a width of the fixed electrode part 51 is thicker than the movable electrode part 52. The oxide film 115 is removed by etching. Thus, the first member 32 in (C) of Fig. 13 is produced.

### (Second member production process)

The process of producing the second member 33 will be described below with reference to Fig. 14. An oxide film 132 is formed on the surface of a Si substrate 131 (cover substrate 71). The drive IC 72 is already prepared in the lower surface of the Si substrate 131. Then a join/connection layer 135 is formed by depositing Ti on the lower surface (the surface opposed to the first member 32) of the cover substrate 71 ((A) of Fig. 14).

Then the join/connection layer 135 is partially removed by etching so as to be left in the join portion and connection portion such as the join part 36 and the connection electrode 82. As a result, the join portion and connection portion such as the join part 36 and the connection electrode 82, which is constructed by the join/connection layer 135, are formed in the lower surface of the cover substrate 71 ((B) of Fig. 14).

An electrode layer 139 is formed in the lower surface of the join/connection layer 135, and the join material 55 made of AuSn is formed in the central portion of the lower surface of the electrode layer 139 ((C) of Fig. 14). As a result, the join portion and connection portion such as the join part 36 and the connection electrode 82 are finished (prepared) in the lower surface of the cover substrate 71 to produce the second member 33 having the structure in (C) of Fig. 14.

### (MEMS switch production process)

The process of producing the MEMS switch 31 by joining the first member 32 and second member 33 produced in the above manner will be described below. The state in which the second member 33 in (C) of Fig. 14 overlaps the first member 32 in (C) of Fig. 13 to perform the metal eutectic bonding to the join material 55 of the second member 33 and the join/connection layer 120 of the first member 32 in each of the join portion or connection portion is illustrated in (A) of Fig. 15. At this point, the space 34 is hermetically sealed.

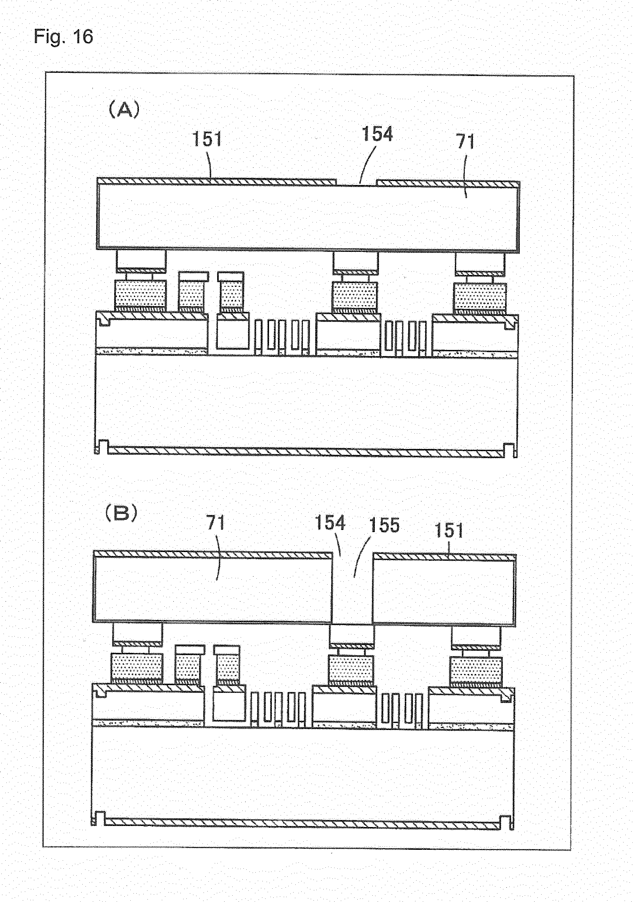

The cover substrate 71 is thinned, and an insulating film 151 is deposited on the upper surface of the cover substrate 71 ((B) of Fig. 15). The insulating film 151 is etched to open a window 154 in the insulating film 151 according to the positions where the through-holes 80, 83, 89, and 92 are made ((A) of Fig. 16). A through-hole 155 is made in the cover substrate 71 with the insulating film 151 as the mask ((B) of Fig. 16).

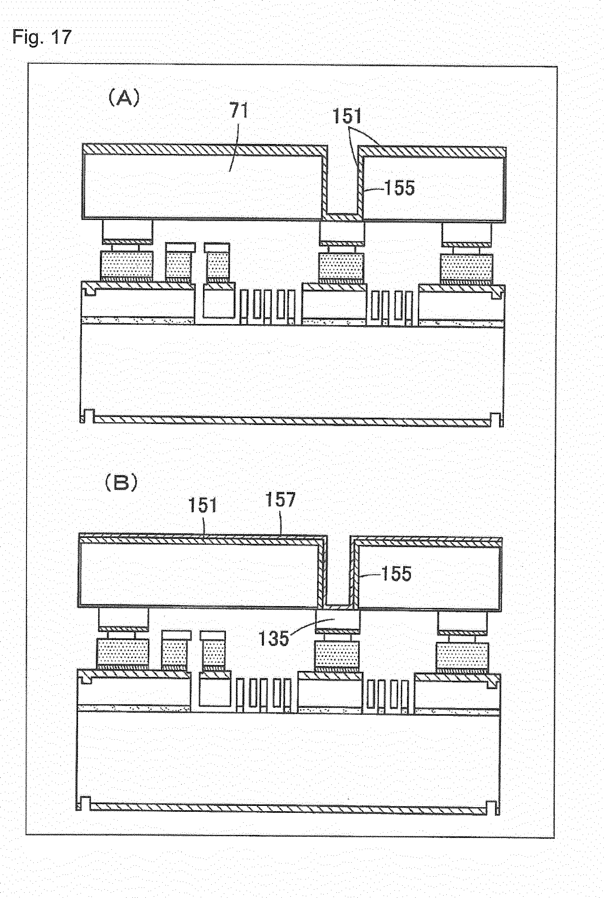

Then, the insulating film is further deposited on an inner surface of the through-hole 155 and the upper surface of the cover substrate 71, and the inner surface of the through-hole 155 and the upper surface of the cover substrate 71 are covered with the insulating film 151 ((A) of Fig. 17). The insulating film 151 on a bottom surface of the through-hole 155 is removed by etching to expose the join/connection layer 135. Then, a conductive layer 157 made of a metallic material such as Cu and Al is provided by, for example, sputtering on an inner peripheral surface of the through-hole 155, the upper surface of the join/connection layer 135, and the upper surface of the cover substrate 71, and the through-hole is made in the through-hole 155 ((B) of Fig. 17).

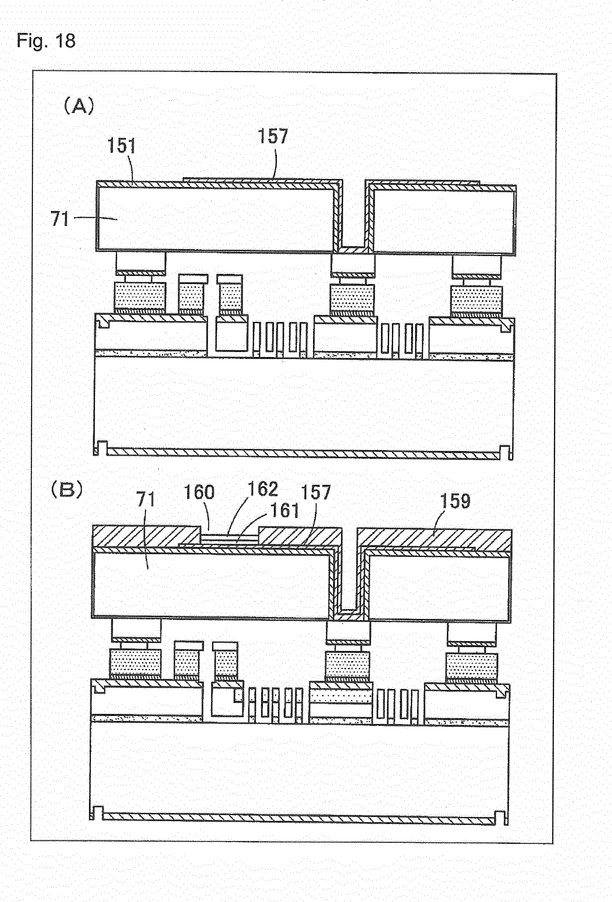

The unnecessary portion of the conductive layer 157 is removed while the through-hole and the regions constituting a flange and a conducting wiring of the through-hole are left, and the flange of the through-hole and the wiring portion electrically conducted to the through-hole are formed ((A) of Fig. 18). The upper surface of the cover substrate 71 is covered with a coating layer 159 made of polyimide, an opening 160 is provided at a proper position of the electrode portion of the through-hole in the coating layer 159, and a Ni plating layer 161 and a Au plating layer 162 are sequentially provided in the opening 160 ((B) of Fig. 18). The bump may be formed on the Au plating layer 162 as needed basis.

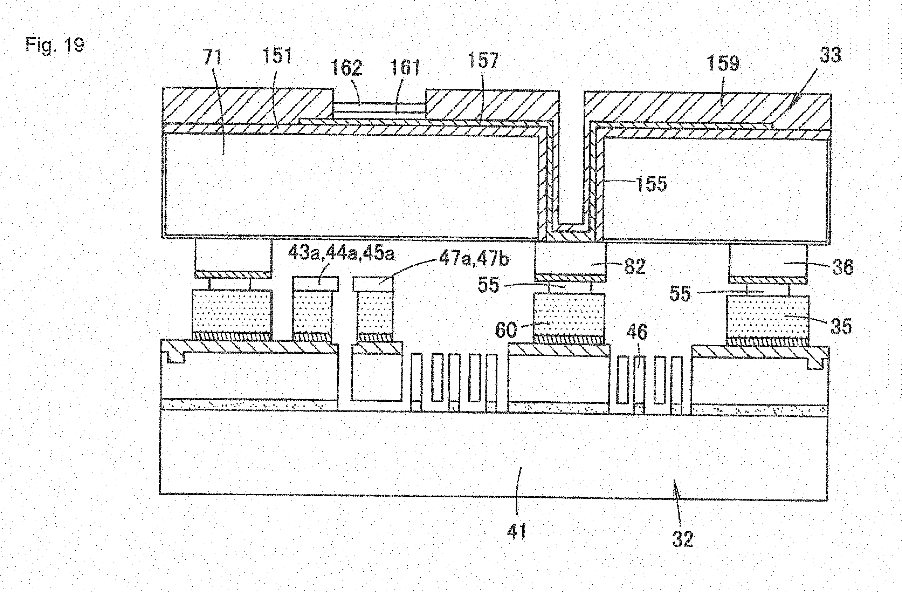

Finally, as illustrated in Fig. 19, the lower surface of the base substrate 41 is polished to thin the first member 32, and the downsized MEMS switch 31 is produced.

### (Second embodiment)

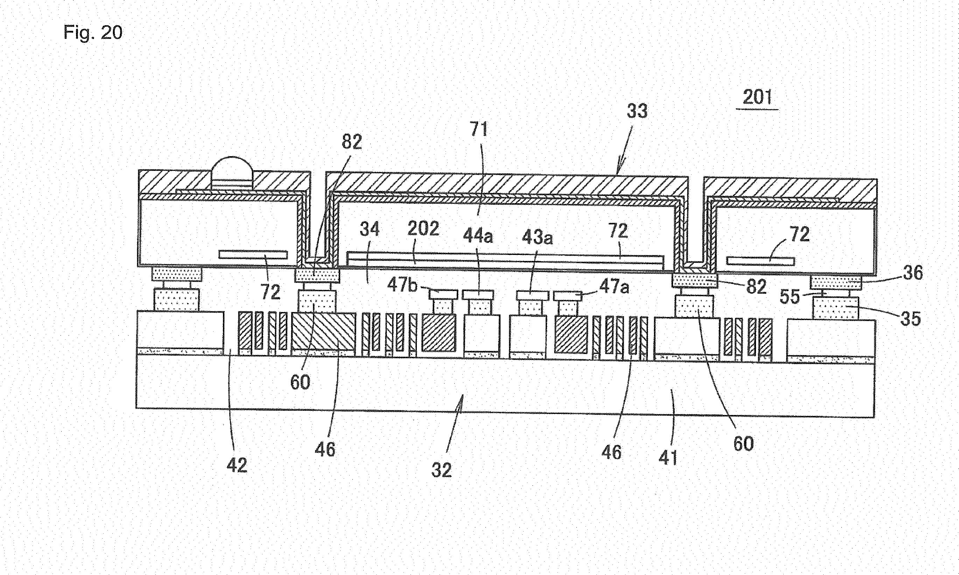

Fig. 20 is a schematic sectional view illustrating a MEMS switch 201 according to a second embodiment of the present invention. In the MEMS switch 201 of the second embodiment, the drive IC 72 is also located above the microstrip including the first to third lines 43 to 45 and the movable contacts 47a and 47b. A metallic shield layer 202 (ground layer) is provided between the drive IC 72 and the first to third lines 43 to 45 such that the drive IC 72 and the first to third lines 43 to 45 are separated from each other.

In the second embodiment, the disposition of the drive IC 72 is hardly restricted, and the drive IC 72 can be provided over a wider wide area. Additionally, impedance of the microstrip line can be designed without considering the influences of the drive IC 72 and the second member 33.

### (Third embodiment)

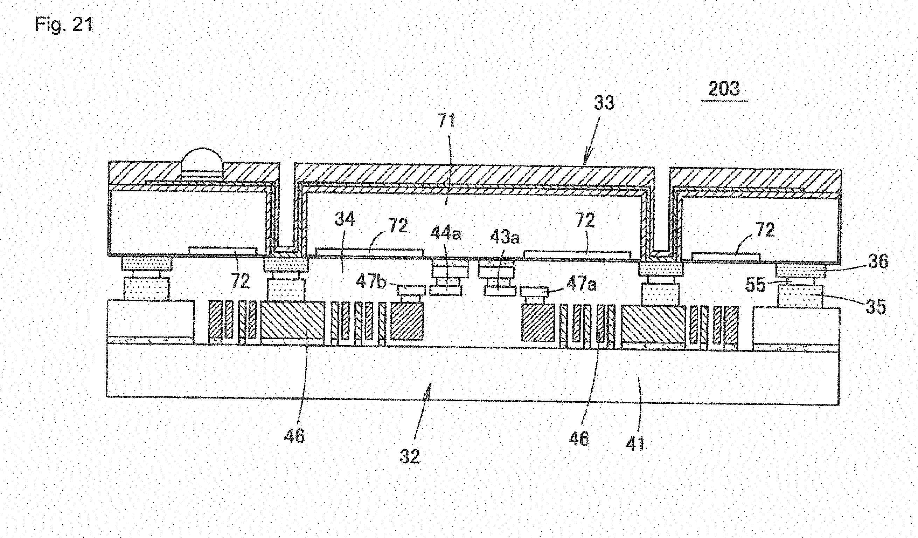

Fig. 21 is a schematic sectional view illustrating a MEMS switch 203 according to a third embodiment of the present invention. In the MEMS switch 203 of the third embodiment, the microstrip line, namely, the first to third lines 43 to 45 are provided in the lower surface of the second member 33. Therefore, the movable contacts 47a and 47b of the electrostatic actuator 46 provided in the first member 32 comes into contact with and separates from the first contact 43a, the second contact 44a, and the common contact 45a of the first to third lines 43 to 45 provided in the second member 33. In the third embodiment, the movable contacts 47a and 47b are provided in the first member 32, and the first contact 43a, the second contact 44a, and the common contact 45a, which constitute fixed contacts, are provided in the second member 33. Therefore, a degree of freedom of the wiring increases.

### (Fourth embodiment)

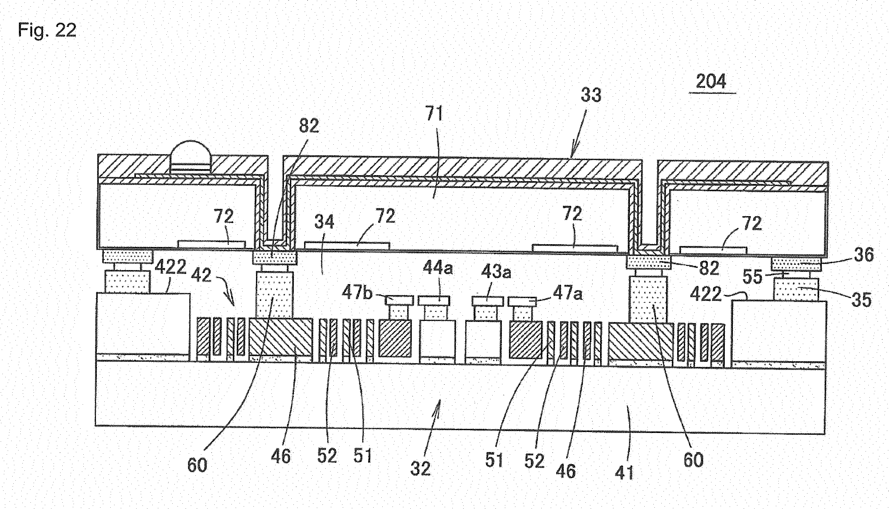

Fig. 22 is a schematic sectional view illustrating a MEMS switch 204 according to a fourth embodiment of the present invention. In the MEMS switch 204 of the fourth embodiment, the electrostatic actuators 46 and 46 are provided in the bottom surface of the recess 42 so as to be located on the lower side of a planar part 422 in the outer periphery of the recess 42. That is, in the first member 32, the recess 42 is formed in the surface opposed to the second member 33, and the electrostatic actuator 46 is disposed in the recess 42 so as not to projected from the recess 42 toward the side of the second member 33 (in other words, the electrostatic actuator 46 is disposed in the recess 42 so as not to projected toward the side of the second member 33 from a virtual plane including the surface of the first member 32 located outside the recess 42 and opposed to the second member 33).

In the third embodiment, because the distance between the electrostatic actuator 46 and the capacitor 75 of the drive IC 72 can be increased, the electrostatic actuator 46 is further hardly influenced by the capacitor 75.

### (Fifth embodiment)

Although not illustrated, an ESD (Electro Static Discharge) protection circuit may be provided in the drive IC 72 in order to protect the drive IC 72 from static electricity. For example, a Zener diode may be provided between a certain portion of the drive IC 72 and the ground in a forward direction from the ground toward the certain portion, In the case that the ESD protection circuit is provided, the Zener diode becomes conductive to release a surge voltage to the ground when the surge voltage is applied to the certain place of the drive IC 72, so that the drive IC 72 can be protected.

### (Summary of embodiments)

The electronic component (MEMS switch) described above includes: the first member in which the electrostatic actuator is provided; the second member in which the drive integrated circuit for driving the electrostatic actuator is provided; and the join parts configured to join the first member and the second member while the surface on which the electrostatic actuator is provided in the first member and the surface on which the drive integrated circuit is provided in the second member are opposed to each other. In the electronic component, the electrostatic actuator and the drive integrated circuit are disposed in the space surrounded by the first member, the second member, and the join parts.

In the configuration, because the first member in which the electrostatic actuator is provided and the second member in which the drive integrated circuit is provided are joined by the join parts while opposed to each other, the drive integrated circuit and the electrostatic actuator can vertically be integrated, and the electronic component can be downsized to reduce the mounting footprint. The wiring length between the drive integrated circuit and the electrostatic actuator can be shortened by integrating the drive integrated circuit and the electrostatic actuator with each other, and the influence of the noise can be reduced in the electronic component. Additionally, the first member in which the electrostatic actuator is provided and the second member in which the drive integrated circuit is provided are joined by the join parts while opposed to each other, thereby constructing the electronic component. Therefore, the production of the electronic component is facilitated.

As described above in the embodiments, in the electronic component (MEMS switch), the drive integrated circuit may include the capacitor, and the capacitor may be disposed such that the direction of the electric field generated in the capacitor intersects the direction of the electric field driving the electrostatic actuator. With such a configuration, because the direction of the electric field generated outside the capacitor by the capacitor is not parallel to the direction of the electric field driving the electrostatic actuator, the electrostatic actuator is hardly influenced by the electric field of the capacitor, and the operation of the electrostatic actuator can be stabilized. Particularly, when the direction of the electric field generated in the capacitor is orthogonal to the direction of the electric field driving the electrostatic actuator, the electrostatic actuator is hardly influenced by the electric field of the capacitor, and the operation of the electrostatic actuator is stabilized.

Desirably the capacitor has the electrostatic capacity larger than that of the electrostatic actuator. With such a configuration, because the capacitor has the electrostatic capacity larger than that of the electrostatic actuator, the previous accumulation of the charges can quickly drive the electrostatic actuator independently of the time necessary to boost the voltage.

As described above in the embodiments, preferably the drive integrated circuit includes the DC-DC converter configured to boost the input voltage to apply the boosted voltage to the electrostatic actuator. With such a configuration, the electrostatic actuator can be driven by boosting the battery voltage in the portable device, and the electronic component (MEMS switch) is desirably applied to a portable device. Particularly the drive integrated circuit desirably includes the charge pump and the capacitor.

As described above in the embodiments, preferably the electrostatic actuator and the drive integrated circuit are sealed in the space. With such a configuration, the durability and weather resistance of the electronic component are improved because the electrostatic actuator and the drive integrated circuit are sealed in the space surrounded by the first member, the second member, and the join parts.

Preferably the electronic component (MEMS switch) further includes: the signal transmission line that is provided in at least one of the first member and the second member; and the movable contact configured to open and close contacts provided in the signal transmission line by operation of the electrostatic actuator. With such a configuration, the movable contact is moved by the electrostatic actuator to be able to open and close the contacts of the signal transmission line. Accordingly, the electronic component can be used as a switch or a relay.

As described above in the embodiments, preferably the electrostatic actuator, the drive integrated circuit, and the signal transmission line are sealed in the space. With such a configuration, the durability and weather resistance of the electronic component are improved because the electrostatic actuator, the drive integrated circuit, and the signal transmission line are sealed in the space constructed by the first member, the second member, and the join parts. Particularly, when oxygen, sulfur and the like are removed from the space, a fluctuation in performance is hardly generated in the contact and movable contact provided in the signal transmission line.

As described above in the embodiments, preferably the drive integrated circuit is provided in the region different from the region opposed to the signal transmission line. With such a configuration, the signal transmitted through the signal transmission line is hardly electrically influenced by the drive integrated circuit, and the influence on the high-frequency signal can be reduced.

As described above in the embodiment, preferably the ground layer is provided between the drive integrated circuit and the signal transmission line such that the drive integrated circuit and the signal transmission line are separated from each other. With such a configuration, the signal transmitted through the signal transmission line is hardly electrically influenced by the drive integrated circuit, and the influence on the high-frequency signal can be reduced.

As described above in the embodiment, preferably the drive integrated circuit includes the circuit configured to release the surge current to the ground. Therefore, a breakage of the electrostatic actuator due to the surge current can be prevented.

As described above in the embodiment, the recess is formed in the surface on the first member, the surface opposed to the second member, and the electrostatic actuator is disposed in the recess so as not to project from the recess toward the side of the second member. With such a configuration, the electrostatic actuator can be disposed distant from the second member. Particularly, because the electrostatic actuator can be disposed distant from the capacitor provided in the second member, the electrostatic actuator is further hardly electrically influenced by the second member (particularly, capacitor).

The present invention is not limited to the above embodiments, but various changes can be made within the scope of the claims. An embodiment obtained by properly combining technical means disclosed in different embodiments is also included in the technical scope of the present invention.

### DESCRIPTION OF SYMBOLS

- 31, 201, 203, 204: MEMS switch
- 32: first member
- 33: second member
- 34: space
- 35, 36: join part
- 41: base substrate
- 42: recess
- 43: first line
- 43a: first contact
- 44: second line
- 44a: second contact
- 45: third line
- 45a: common contact
- 46: electrostatic actuator
- 47a, 47b: movable contact
- 51: fixed electrode part
- 52: movable electrode part
- 55: join material
- 71: cover substrate
- 72: drive IC
- 74: charge pump circuit
- 75: capacitor
- 86: output electrode
- 87: connection electrode
- 88: input terminal
- 91: ground terminal
- 93: output terminal
- 202: metallic shield layer

## Claims

1. An electronic component comprising:
a first member in which an electrostatic actuator is provided;
a second member in which a drive integrated circuit for driving the electrostatic actuator is provided; and
join parts configured to join the first member and the second member while a surface on which the electrostatic actuator is provided in the first member and a surface on which the drive integrated circuit is provided in the second member are opposed to each other,
wherein the electrostatic actuator and the drive integrated circuit are disposed in a space surrounded by the first member, the second member, and the join parts.

2. The electronic component according to claim 1 wherein
the drive integrated circuit comprises a capacitor, and
the capacitor is disposed such that a direction of an electric field generated in the capacitor intersects a direction of an electric field driving the electrostatic actuator.

3. The electronic component according to claim 2, wherein the direction of the electric field generated in the capacitor is orthogonal to the direction of the electric field driving the electrostatic actuator.

4. The electronic component according to claim 2, wherein the capacitor comprises an electrostatic capacity larger than that of the electrostatic actuator.

5. The electronic component according to claim 1, wherein the drive integrated circuit comprises a DC-DC converter configured to boost an input voltage to apply the boosted voltage to the electrostatic actuator.

6. The electronic component according to claim 5, wherein the drive integrated circuit comprises a charge pump and a capacitor.

7. The electronic component according to claim 1, wherein the electrostatic actuator and the drive integrated circuit are sealed in the space.

8. The electronic component according to claim 1, further comprising:
a signal transmission line that is provided in at least one of the first member and the second member; and
a movable contact configured to open and close contacts provided in the signal transmission line by operation of the electrostatic actuator.

9. The electronic component according to claim 8, wherein the electrostatic actuator, the drive integrated circuit, and the signal transmission line are sealed in the space.

10. The electronic component according to claim 8, wherein the drive integrated circuit is provided in a region different from a region opposed to the signal transmission line.

11. The electronic component according to claim 8, wherein aground layer is provided between the drive integrated circuit and the signal transmission line such that the drive integrated circuit and the signal transmission line are separated from each other.

12. The electronic component according to claim 1; wherein the drive integrated circuit comprises a circuit configured to release a surge current to a ground.

13. The electronic component according to claim 1, wherein
a recess is formed in a surface on the first member, the surface opposed to the second member, and
the electrostatic actuator is disposed in the recess so as not to project from the recess toward a side of the second member.
